# EUROPEAN PATENT SPECIFICATION

(11) **EP 2 447 731 B1**
(45) Date of publication and mention of the grant of the patent: **03.07.2013**
(21) Application number: 11186111.8
(22) Date of filing: 21.10.2011
(51) Int. Cl.: G01R 33/00

(54) **Magnetic sensor**
Magnetsensor
Capteur magnétique

(30) Priority: 29.10.2010 JP 2010244756
(43) Date of publication of application: 02.05.2012
(73) Proprietor: Murata Manufacturing Co., Ltd., Kyoto 617-8555 (JP)
(72) Inventor: Tomaki Kenji, Kyoto 617-8555 (JP); Nakamura Munehisa, Kyoto 617-8555 (JP)
(74) Representative: Reeve, Nicholas Edward

(56) References cited:
- JP-A- 2010 127 756

## Description

### BACKGROUND OF THE INVENTION

### 1. Field of the Invention

The present invention relates to a magnetic sensor that identifies a bill (paper money) or the like.

### 2. Description of the Related Art

A magnetic sensor is used for reading and identifying information such as a number, a character, or a symbol printed with a magnetic ink etc. on a detection object such as a bill or a security. The magnetic sensor is arranged in a bill identifying device of, for example, an automated teller machine (ATM). For example, such a magnetic sensor is disclosed in Japanese Unexamined Patent Application Publication No. 2010-175490 or No. 2010-127756. Referring to Fig. 6, the magnetic sensor disclosed in Japanese Unexamined Patent Application Publication No. 2010-175490 includes a case 110, a cover 115, a magnetoresistive element 111 and a magnet 114. The case 110 has cover attachment grooves 121 at side surfaces of the case 110. The cover 115 includes a top portion that faces a magnetism detection surface, and side portions that are formed substantially perpendicularly to the top portion. The side portions of the cover 115 are inserted into the cover attachment grooves 121. The cover attachment grooves 121 are filled with a thermosetting resin 116. The case 110 and the cover 115 are fixed with the resin 116.

As described above, with the magnetic sensor of related art, the case and cover are attached together by a method of fitting the cover into the cover attachment grooves of the case, then filling the cover attachment grooves with the resin, and hardening the resin. Hence, the process may be complicated. Also, since the cover attachment grooves are provided at the side portions of the case, the size of the magnetic sensor may be increased.

### SUMMARY OF THE INVENTION

An aim of the present invention is to provide a small magnetic sensor by a simple process. The present invention is defined in the independent claim to which reference is now directed. Preferred features are set out in the dependent claims.

According to preferred embodiments of the present invention, a magnetic sensor includes a substantially rectangular-parallelepiped case including an upper wall and a plurality of side walls extending from the upper wall substantially perpendicularly to the upper wall, the case having a housing portion therein; a magnet provided in the housing portion; a magnetoelectric conversion element provided outside the upper wall of the case; and a cover provided to cover the upper wall and the plurality of side walls. A resin, which is the same as a resin that fills a space between the housing portion of the case and the magnet and a space between the case and the cover, bonds and fixes the case and the magnet together and the case and the cover together.

Preferably in the magnetic sensor, the cover may be provided to cover the upper wall and two facing side walls among the plurality of side walls.

Preferably in the magnetic sensor, the cover may be provided to cover the entire surfaces of the two facing side walls of the case.

Preferably in the magnetic sensor, a notch may be provided at the side walls of the case covered with the cover.

Preferably in the magnetic sensor, a hole may be provided at the side walls of the case covered with the cover.

Preferably in the magnetic sensor, a groove that prevents the flow of the resin may be provided at the side walls of the case covered with the cover.

Preferably in the magnetic sensor, the groove may be provided at the side walls at a position near the upper wall.

Preferably in the magnetic sensor, the groove may be provided in parallel to lines on which the side walls contact the upper wall.

Preferably in the magnetic sensor, at least a hole that stops the flow of the resin is provided at a portion of the cover covering the side walls of the case.

With the preferred embodiments of the present invention fixing of the magnet, and fixing of the cover and the case are simultaneously performed with the same resin. Accordingly, the case can be fixed by the simple process. Also, since the cover attachment grooves do not have to be provided unlike the process of related art, the size of the magnetic sensor can be reduced.

Other features, elements, characteristics and advantages of the present invention will become more apparent from the following detailed description of preferred embodiments of the present invention with reference to the attached drawings.

### BRIEF DESCRIPTION OF THE DRAWINGS

Preferred embodiments of the present invention will now be described, by way of example only, with reference to the accompanying drawings, in which:
Fig. 1A is a perspective view showing a magnetic sensor according to a first embodiment of the invention, and Fig. 1B is a cross―sectional view taken along line M-M in Fig. 1A according to the first embodiment;
Fig. 2 is an exploded perspective view showing a case and a cover that are used for the magnetic sensor according to the first embodiment;
Fig. 3 is a cross-sectional view when the magnetic sensor according to the first embodiment is used for a bill identifying device;
Fig. 4 is an exploded perspective view showing a case and a cover that are used for a magnetic sensor according to a second embodiment of the invention;
Fig. 5 is an exploded perspective view showing a case and a cover that are used for a magnetic sensor according to a third embodiment of the invention; and

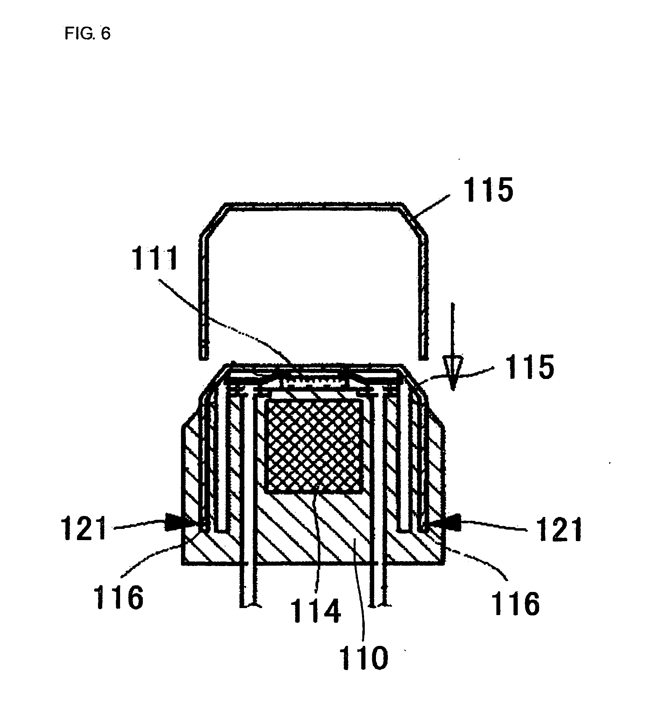

Fig. 6 is a cross-sectional view showing a magnetic sensor according to related art.

### DESCRIPTION OF THE PREFERRED EMBODIMENTS

Embodiments for implementing the present invention will be described below.

### First Embodiment

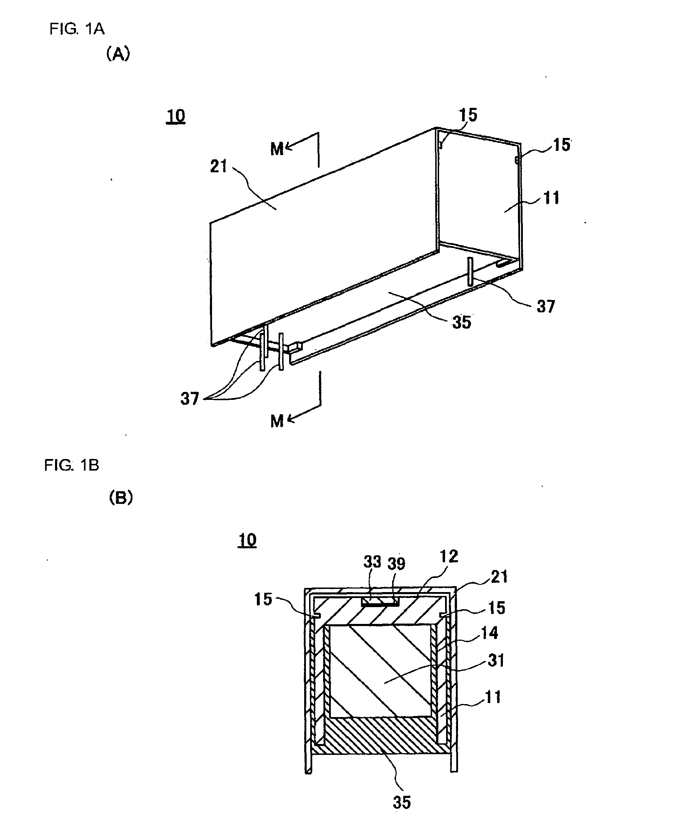

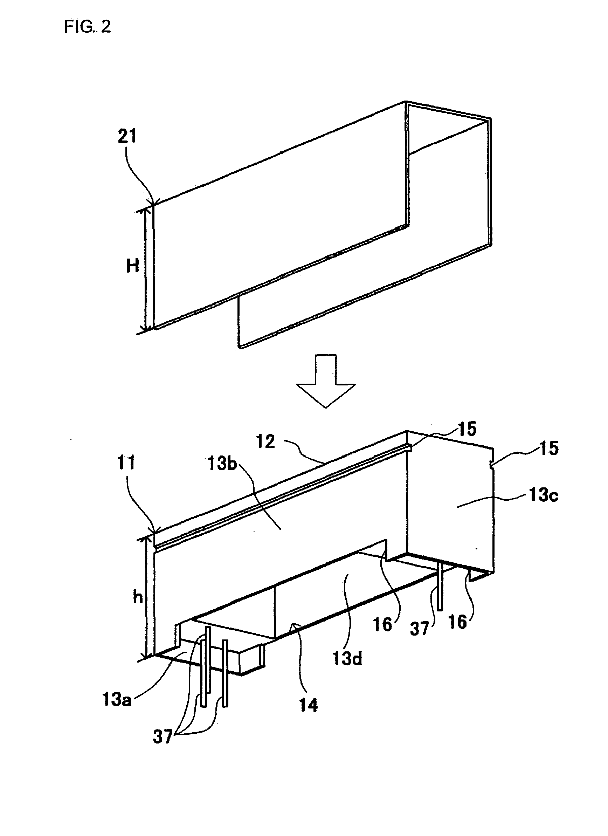

Fig. 1A is a perspective view showing a magnetic sensor according to a first embodiment of the invention. Fig. 1B is a cross-sectional view taken along line M-M in Fig. 1A. Also, Fig. 2 is an exploded perspective view showing a case and a cover that are used for the magnetic sensor according to the first embodiment. Description will be given with reference to Figs. 1A, 1B, and 2.

Referring to Fig. 1B, a magnetic sensor 10 includes a case 11, a magnet 31, a magnetoresistive element 33, and a cover 21.

Referring to Fig. 2, the case 11 is a substantially rectangular-parallelepiped box case having a lower plane being open. In particular, the case 11 includes a substantially rectangular upper wall 12, and a plurality of side walls 13a, 13b, 13c, and 13d that respectively extend from edges of the upper wall 12 substantially perpendicularly from a principal plane of the upper wall 12. The case 11 has a housing portion 14 being open to the lower side of the case 11. The housing portion 14 has steps near the side walls 13a and 13c. In this embodiment, the case 11 is made of polyphenylene sulfide (PPS) resin. Alternatively, the material of the case 11 may be a thermoplastic resin such as liquid crystal polymer (LCP), or a thermosetting resin such as phenolic resin.

Pin terminals 37 are provided at the steps of the housing portion 14. The pin terminals 37 penetrate through the steps of the housing portion 14. First ends of the pin terminals 37 are exposed from the upper wall 12 of the case 11, and second ends of the pin terminals 37 extend to the lower side of the case 11. The pin terminals 37 are used for electrically connect the magnetic sensor with an external circuit. The material of the pin terminals 37 may be a copper alloy treated by tinning.

The magnet 31 is made of a substantially rectangular-parallelepiped magnetic material. The magnetoresistive element 33 includes a substantially rectangular element body and lead terminals (not shown) extending from an end portion of the element body. The magnetoresistive element 33 is an element having a resistance value that is variable in accordance with a change of a magnetic field. The magnetoresistive element 33 is fabricated, for example, by forming an InSb film on a surface of a silicon substrate.

Referring to Fig. 1B, the magnet 31 is provided inside the case 11, and the magnetoresistive element 33 is provided outside the case 11, with the upper wall 12 interposed between the magnet 31 and the magnetoresistive element 33. To be more specific, the magnet 31 is housed in the housing portion 14 such that a surface of the magnet 31 contacts the inner side of the upper wall 12. The magnetoresistive element 33 is housed in a recess portion that is provided at the outer side of the upper wall 12. The element body of the magnetoresistive element 33 is bonded to a bottom surface of the recess portion with an adhesive layer 39 interposed between the element body and the bottom surface. The lead terminals are electrically connected with the first ends of the pin terminals 37. The recess portion has a depth that is larger than a combined thickness of the magnetoresistive element 33 and the adhesive later 39. The magnet 31 is provided to apply a biased magnetic field to the magnetoresistive element 33. Hence, an area of a portion of the magnet 31 facing the magnetoresistive element 33 is designed to be larger than an area of a portion of the magnetoresistive element 33 facing the magnet 31.

The magnetoresistive element 33 may be other magnetoelectric conversion element such as a Hall element. The material of the adhesive layer 39 is preferably a silicon resin or the like with a high elastic coefficient so as to absorb mechanical vibration from the outside. Alternatively, the magnetoresistive element 33 may be directly attached to the outer side of the upper wall 12 of the case 11. In this case, for example, a protrusion protruding by a height that is larger than the thickness of the magnetoresistive element 33 may be provided at the case 11, as a positioning member. The magnetoresistive element 33 may be fixed by the protrusion.

Referring to Fig. 2, the cover 21 includes three members that respectively cover the upper wall 12 of the case 11 and the two facing side walls 13b and 13d among the plurality of side walls of the case 11. In this embodiment, the cover 21 is formed by bending a stainless-steel plate member. Hence, the cover 21 can be easily processed. Alternatively, the material of the cover 21 may be a metal other than the stainless steel, or a conductive resin.

Referring to Fig. 1B, the housing portion 14 of the case 11 is filled with a resin 35 that is made of a thermosetting resin such as epoxy resin to fix the magnet 31. The resin 35 leaking from the housing portion 14 is spread into a space between the case 11 and the cover 21, which closely contact each other, by a capillary action. Hence, the resin 35 fixes the magnet 31, and bonds the cover 21 to the case 11. Further, unlike the case of related art, the cover attachment grooves do not have to be provided. The size of the case 11 can be reduced by the amount of the cover attachment grooves. Accordingly, the size of the magnetic sensor 10 can be reduced.

The cover 21 is formed preferably to cover the entire surfaces of the two facing side walls 13b and 13d of the case 11. In particular, as shown in Fig. 2, the cover 21 preferably has a height H larger than a height h of the side walls 13a, 13b, 13c, and 13d of the case 11. Accordingly, the resin 35 can be reliably spread into the space between the case 11 and the cover 21.

The side walls 13b and 13d of the case 11 covered with the cover 21 have notches 16. With the notches 16, the resin 35 can reliably leak from the case 11 even if the amount of the resin 35 is small.

The side walls 13b and 13d of the case 11 covered with the cover 21 also have grooves 15 that prevent the resin 35 from reaching the magnetoresistive element 33 even if the amount of the resin 35 is large. The resin 35 spreading into the space between the case 11 and the cover 21 by the capillary action flows into the grooves 15 but does not flow to the magnetoresistive element 33. The grooves 15 are provided at the side walls 13b and 13d preferably at positions near the upper wall 12. Accordingly, the amount of the resin 35 flowing into the grooves 15 is decreased, and a bonding area between the case 11 and the cover 21 is increased. The number of the groove 15 may be plural. Also, the groove 15 is provided preferably in parallel to lines on which the side walls 13b and 13d contact the upper wall 12. In this case, the groove 15 can be easily formed.

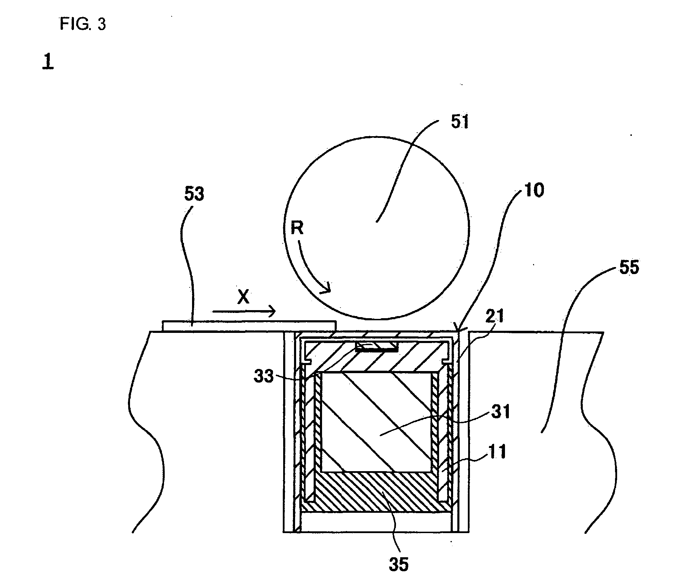

A problem that occurs if the resin 35 reaches the magnetoresistive element 33 will be described below. Fig. 3 is a cross-sectional view when the magnetic sensor according to the first embodiment is used for a bill identifying device. A bill identifying device 1 includes the magnetic sensor 10, a stage 55 that supports the magnetic sensor 10, and a roller 51 provided at a position at which the roller 51 faces the magnetic sensor 10. A rotation direction of the roller 51 is a direction indicated by arrow R. A detection subject 53 such as a bill (paper money) is conveyed along a circumferential surface of the roller 51 in a direction indicated by arrow X.

If no gap is provided between the cover 21 and the magnetoresistive element 33, a pressure from the roller 51 directly propagates to the magnetoresistive element 33, and a noise is generated as the result of the pressure. Owing to this, a phenomenon in which the resin 35 reaches the magnetoresistive element 33 and fills the gap has to be prevented from occurring.

For example, the magnetic sensor according to this embodiment is manufactured as follows.

First, a case made of PPS resin and fabricated by ejection molding is prepared. Then, pin terminals are press-fitted into the case. The pin terminals are substantially round bars formed such that a copper alloy material is treated by tinning.

Then, a magnetoresistive element is provided outside an upper wall of the case. An element body having a plurality of resistive elements is prepared. Then, a frame formed such that a copper material is treated by tinning is prepared. First ends of a plurality of lead terminals are commonly coupled with the frame. An end portion of the element body is connected with second ends of the lead terminals, and then the lead terminals are separated from the frame. Accordingly, the magnetoresistive element is formed. The magnetoresistive element is bonded and fixed to a recess portion of the case with silicon resin. Then, the lead terminals and the pin terminals are bonded by heat sealing at a temperature in a range from about 360 to about 400 degrees centigrade, and hence are electrically connected with each other.

Next, while an open part of a housing portion of the case is directed upward, a magnet is inserted into the housing portion defined in the case.

Then, a cover is fitted to the case from the upper wall side.

Then, the inside of the case is filled with epoxy resin, which is a thermosetting resin, to bond and fix the case and the magnet together, and the case and the cover together simultaneously at a temperature of about 120 degrees centigrade. The resin leaking from the housing portion is spread into a space between the case and the cover, which closely contact each other, by a capillary action. Hence, the resin fixes the magnet, and simultaneously, bonds the cover to the case.

The magnetic sensor is manufactured by the above-described method.

### Second Embodiment

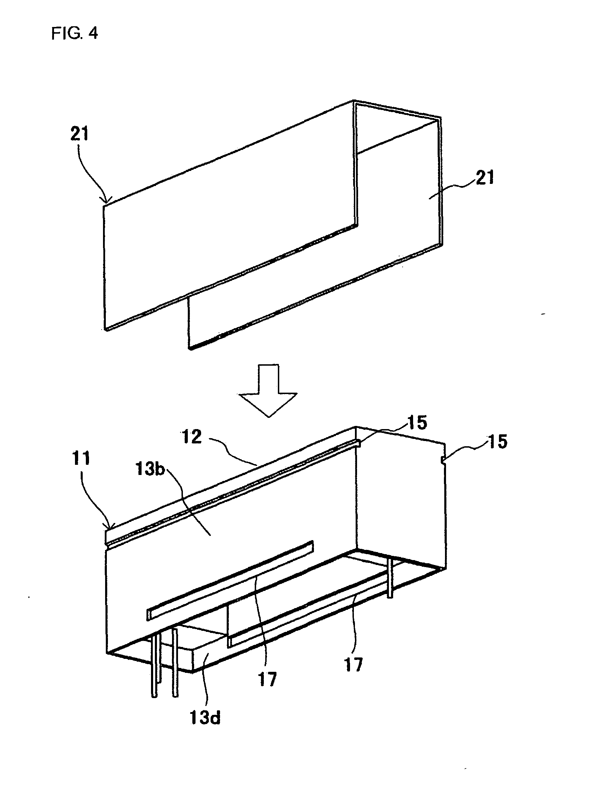

Also, Fig. 4 is an exploded perspective view showing a case and a cover that are used for a magnetic sensor according to a second embodiment of the invention. Description for part of the second embodiment common to the first embodiment is omitted.

In this embodiment, holes 17 are formed at the side walls 13b and 13d of the case 11 covered with the cover 21, instead of the notches. The holes 17 can cause the resin 35 to smoothly flow from the housing portion 14 in the case 11 to the space between the case 11 and the cover 21, in a manner similar to the notches.

### Third Embodiment

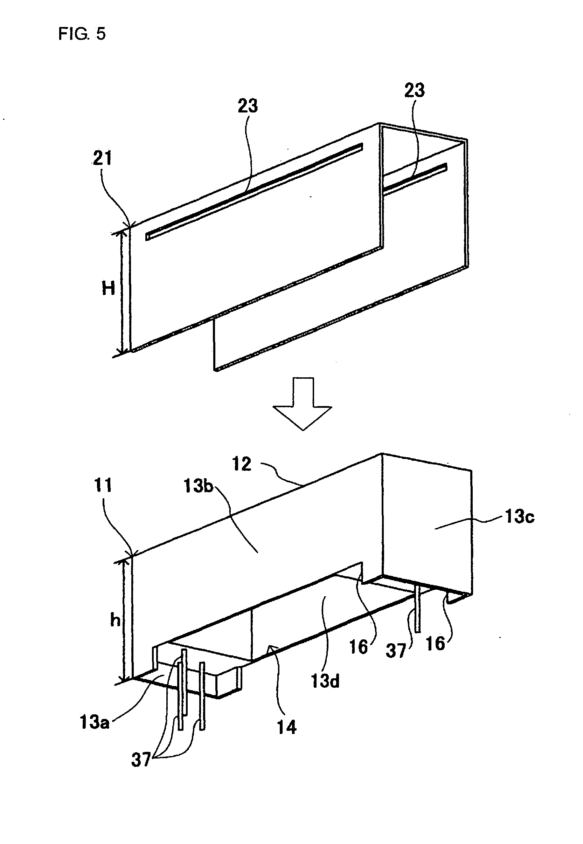

Fig. 5 is an exploded perspective view showing a case and a cover that are used for a magnetic sensor according to a third embodiment of the invention.

Referring to Fig. 5, preferably, at least a hole 23 may be provided at a portion of the cover 21 covering the side walls 13b and 13d, as a structure that attains an advantage similar to the advantage of the grooves at the case. The holes 23 each may have any shape like a substantially circular shape or a substantially rectangular shape. A gap between the case 11 and the cover 21 is increased at edges of the hole 23. Hence, flow of the resin is stopped by surface tension. If both the grooves at the case 11 and the holes 23 at the cover 21 are provided, the flow of the resin can be effectively controlled. Thus, this structure is preferable.

Alternatively, as a structure that attains an advantage similar to the advantage of the grooves at the case, grooves may be formed at the cover 21 at portions covering the side walls 13b and 13d, so as to increase gaps between the cover 21 and the side walls 13b and 13d. The gap between the case 11 and the cover 21 is increased at the grooves, and the flow of the resin is stopped by surface tension.

While preferred embodiments of the invention have been described above, it is to be understood that variations and modifications will be apparent to those skilled in the art without departing from the scope of the invention. The scope of the invention, therefore, is to be determined solely by the following claims.

## Claims

1. A magnetic sensor (10), comprising:
a substantially rectangular-parallelepiped case (11) including an upper wall (12) and a plurality of side walls (13a, 13b, 13c, 13d) extending from the upper wall substantially perpendicularly to the upper wall, the case having a housing portion (14) inside;
a magnet (31) provided in the housing portion;
a magnetoelectric conversion element (33) provided outside the upper wall of the case; and
a cover (21) provided to cover the upper wall and the plurality of side walls,
wherein a resin (35), which is the same as a resin that fills a space between the housing portion of the case and the magnet and a space between the case and the cover, bonds and fixes the case and the magnet together and the case and the cover together, wherein the housing portion of the case is configured such that resin can leak from the housing portion of the case to the space between the case and the cover, and wherein the case and the cover are arranged close to each other, whereby the resin can spread into the space between the case and the cover by capillary action.

2. The magnetic sensor according to claim 1, wherein the cover is provided to cover the upper wall and two facing side walls (13b, 13d) among the plurality of side walls.

3. The magnetic sensor according to claim 2, wherein the cover is provided to cover the entire surfaces of the two facing side walls among the plurality of side walls.

4. The magnetic sensor according to any of claims 1 to 3, wherein a notch (16) is provided at the plurality of side walls covered with the cover.

5. The magnetic sensor according to any of claims 1 to 4, wherein a hole (17) is provided at the plurality of side walls covered with the cover.

6. The magnetic sensor according to any of claims 1 to 5, wherein a groove (15) adapted to prevent the flow of the resin is provided at the plurality of side walls covered with the cover.

7. The magnetic sensor according to claim 6, wherein the groove is provided at the plurality of side walls at a position near the upper wall.

8. The magnetic sensor according to claim 6 or 7,
wherein the groove is provided in parallel to a line on which the plurality of side walls contact the upper wall.

9. The magnetic sensor according to any of claims 1 to 8, wherein at least a hole (23) that prevents the flow of the resin is provided at a portion of the cover where the cover covers the plurality of side walls.

## Patentansprüche

1. Magnetsensor (10), der Folgendes umfasst:
einen Kasten (11) im Wesentlichen in der Form eines rechteckigen Spats mit einer oberen Wand (12) und mehreren Seitenwänden (13a, 13b, 13c, 13d), die von der oberen Wand im Wesentlichen lotrecht zur oberen Wand verlaufen, wobei der Kasten innen einen Gehäuseabschnitt (14) aufweist;
einen in dem Gehäuseabschnitt vorgesehenen Magnet (31);
ein magnetoelektrisches Wandlungselement (33), das außerhalb der oberen Wand des Kastens vorgesehen ist; und
eine Abdeckung (21), die zum Abdecken der oberen Wand und der mehreren Seitenwände vorgesehen ist,
wobei ein Harz (35), das dasselbe ist wie ein Harz, das einen Raum zwischen dem Gehäuseabschnitt des Kastens und dem Magnet und einen Raum zwischen dem Kasten und der Abdeckung ausfüllt, den Kasten und den Magnet sowie den Kasten und die Abdeckung aneinander klebt und befestigt, wobei der Gehäuseabschnitt des Kastens so konfiguriert ist, dass das Harz aus dem Gehäuseabschnitt des Kastens in den Raum zwischen dem Kasten und dem Deckel auslaufen kann, und wobei der Kasten und der Deckel nahe beieinander angeordnet sind, so dass sich das Harz durch Kapillarwirkung in den Raum zwischen dem Kasten und dem Deckel ausbreiten kann.

2. Magnetsensor nach Anspruch 1, wobei die Abdeckung zum Abdecken der oberen Wand und von zwei einander zugewandten Seitenwänden (13b, 13d) unter den mehreren Seitenwänden vorgesehen ist.

3. Magnetsensor nach Anspruch 2, wobei die Abdeckung zum Abdecken der gesamten Oberflächen der beiden einander
zugewandten Seitenwände unter den mehreren Seitenwänden vorgesehen ist.

4. Magnetsensor nach einem der Ansprüche 1 bis 3, wobei eine Kerbe (16) an den mehreren mit der Abdeckung bedeckten Seitenwänden vorgesehen ist.

5. Magnetsensor nach einem der Ansprüche 1 bis 4, wobei ein Loch (17) an den mehreren mit der Abdeckung bedeckten Seitenwänden vorgesehen ist.

6. Magnetsensor nach einem der Ansprüche 1 bis 5, wobei eine Nut (15) zum Verhindern des Flusses des Harzes an den mehreren mit der Abdeckung bedeckten Seitenwänden vorgesehen ist.

7. Magnetsensor nach Anspruch 6, wobei die Nut an den mehreren Seitenwänden in einer Position nahe der oberen Wand vorgesehen ist.

8. Magnetsensor nach Anspruch 6 oder 7, wobei die Nut parallel zu einer Linie vorgesehen ist, auf der die mehreren Seitenwände mit der oberen Wand in Kontakt kommen.

9. Magnetsensor nach einem der Ansprüche 1 bis 8, wobei wenigstens ein Loch (23), das den Fluss des Harzes verhindert, an einem Abschnitt der Abdeckung vorgesehen ist, wo die Abdeckung die mehreren Seitenwände bedeckt.

## Revendications

1. Capteur magnétique (10), comprenant :
un boîtier sensiblement rectangulaire en parallélépipède (11) comprenant une paroi supérieure (12) et une pluralité de parois latérales (13a, 13b, 13c, 13d) s'étendant de la paroi supérieure dans un plan sensiblement perpendiculaire à la paroi supérieure, le boîtier ayant une partie de logement (14) à l'intérieur;
un aimant (31) fourni dans la partie de logement;
un élément de conversion magnéto-électrique (33) fourni à l'extérieur de la paroi supérieure du boîtier; et
un couvercle (21) fourni pour couvrir la paroi supérieure et la pluralité de parois latérales,
dans lequel une résine (35), qui est la même qu'une résine qui remplit un espace entre la partie de logement du boîtier et l'aimant et un espace entre le boîtier et le couvercle, lie et fixe le boîtier et l'aimant ensemble et le boîtier et le couvercle ensemble, dans lequel la partie de logement du boîtier est configurée de telle sorte que la résine peut s'écouler de la partie de logement du boîtier vers l'espace entre le boîtier et le couvercle et dans lequel le boîtier et le couvercle sont disposés près l'un de l'autre, en vertu de quoi la résine peut s'étaler dans l'espace entre le boîtier et le couvercle par action capillaire.

2. Capteur magnétique selon la revendication 1, dans lequel le couvercle est fourni pour couvrir la paroi supérieure et deux parois latérales face-à-face (13b, 13d) parmi la pluralité de parois latérales.

3. Capteur magnétique selon la revendication 2, dans lequel le couvercle est fourni pour couvrir les surfaces entières des deux parois latérales face-à-face parmi la pluralité de parois latérales.

4. Capteur magnétique selon l'une quelconque des revendications 1 à 3, dans lequel une entaille (16) est fournie au niveau de la pluralité de parois latérales couvertes par le couvercle.

5. Capteur magnétique selon l'une quelconque des revendications 1 à 4, dans lequel un trou (17) est fourni au niveau de la pluralité de parois latérales couvertes par le couvercle.

6. Capteur magnétique selon l'une quelconque des revendications 1 à 5, dans lequel une rainure (15) adaptée pour empêcher l'écoulement de la résine est fournie au niveau de la pluralité de parois latérales couvertes par le couvercle.

7. Capteur magnétique selon la revendication 6, dans lequel la rainure est fournie au niveau de la pluralité de parois latérales à une position près de la paroi supérieure.

8. Capteur magnétique selon la revendication 6 ou 7, dans lequel la rainure est fournie à la parallèle d'une ligne sur laquelle la pluralité de parois latérales contactent la paroi supérieure.

9. Capteur magnétique selon l'une quelconque des revendications 1 à 8, dans lequel au moins un trou (23) qui empêche l'écoulement de la résine, est fourni au niveau d'une partie du couvercle où le couvercle couvre la pluralité de parois latérales.
